# EUROPEAN PATENT SPECIFICATION

(11) **EP 1 162 656 B1**
(45) Date of publication and mention of the grant of the patent: **26.10.2005**
(21) Application number: 01116591.7
(22) Date of filing: 04.07.1995
(51) Int. Cl.: H01L 21/768

(54) **Filling holes and the like in substrates**
Füllen von Löchern und Ähnlichem in Substraten
Remplissage de trous et analogues dans des substrats

(30) Priority: 13.07.1994 GB 9414145
(43) Date of publication of application: 12.12.2001
(62) Divisional of application: 95923491.5
(73) Proprietor: Trikon Technologies Limited, Newport, Gwent NP6 2TA (GB)
(72) Inventor: Dobson, Christopher David, Bristol BS12 3AA (GB); McGeown, Arthur John, Bristol BS6 6XB (GB)
(74) Representative: Dunlop, Brian Kenneth Charles

(56) References cited:
- EP-A- 0 516 344
- US-A- 4 906 823

## Description

The present invention relates to arrangements for filling holes (such as "VIAS") or the like in surfaces, for example, surfaces which are deposited on semi-conductor wafers or similar substrates.

In European Patent Application No. EP-A-0516344 we discuss the general problems associated with such holes and propose depositing a layer of aluminium or aluminium alloy so as to bridge a recess such as a hole or trench and then subjecting that layer to elevated pressure and elevated temperature to fill the hole. Further developments of this proposal are discussed in European Patent Application No. EP-A-0621980.

In all these proposals, the layer is deposited onto the surface of the substrate using a known deposition process such as chemical vapour deposition or sputtering. EP-A-0 516 344 further discloses positioning a pre-formed metal layer across the recesses. As the holes and recesses to be filled become progressively smaller, it has become progressively more difficult to achieve suitable deposition of the aluminium or aluminium alloy layers and it has become even more difficult to achieve satisfactory deposition at the bottom of the holes or recesses of a suitable barrier layer to prevent spiking of the aluminium into the substrate.

The invention consists in a method of filling recesses (which term includes trenches, holes or vias) formed in a film or layer deposited on a substrate, comprising laying a metallic foil across the exposed surface of the film to bridge the recesses, heating the foil and applying pressure to the foil, whereby the foil or material therefrom is forced into the recesses to fill them, characterised in that the foil is mounted on or supported by a carrier layer and in that the method further includes a step of stripping the carrier layer after laying said foil across said exposed surface.

Usually the stripping step will be performed prior to the application of pressure, but if, for example, mechanical pressure is to be applied then there may be benefits in retaining the carrier layer at that stage.

The heating step may precede or be simultaneous with the application of pressure.

The pressure may be induced mechanically through a solid or fluid, or it may be applied by creating a pressure drop across the foil. In this latter case a step of creating a pressure drop may include evacuating the recesses either before, during or after the foil has been laid on the surface. The pressure may then be raised on the exposed side of the foil and preferably the initial increase in pressure is sufficiently sudden to seal the foil against the film and hence preclude the pressure in the recesses being raised. Alternatively a mechanical seal could be formed around the periphery of the film.

The foil is preferably a highly-conducting ductile metal such as aluminium, an aluminium alloy, copper or gold.

When the foil is aluminium or aluminium alloy, a barrier or lubrication layer may be provided of Titanium or Titanium Nitride and there may be more than one such layer, for example, there may be a sandwich of Titanium, Titanium Nitride and Titanium.

One surface of the foil may be coated with one or more barrier and/or lubricating layers and these may be Titanium and or Titanium Nitride or a combination thereof. The foil may be mounted on an organic carrier layer on the opposite side to the barrier or lubricating layer or layers if they exist and that organic carrier layer may be a mylar.

It will be appreciated that the use of such foils in the method described above are particularly advantageous, because they can be pre-prepared in accordance with the specific situation in which they are intended to act and are not dependent either upon the environmental conditions within the processing chamber or the nature or topography of the substrate or film on which they are laid.

The invention may be performed in various ways and specific embodiments will now be described with reference to the accompanying drawings, in which:
Figure 1 shows the cross sectional view of a part of a semi-conductor wafer with a foil laid on the top thereof;
Figure 2 shows the cross sectional view of the wafer of Figure 1 after the foil has been subjected to elevated pressure and temperature;
Figure 3 corresponds to Figure 1, but in this case the foil includes a carrier layer and barrier or lubricating layers;
Figure 4 shows the wafer of Figure 3 after the foil has been subjected to elevated temperatures and pressures and the carrier layer has been stripped away.

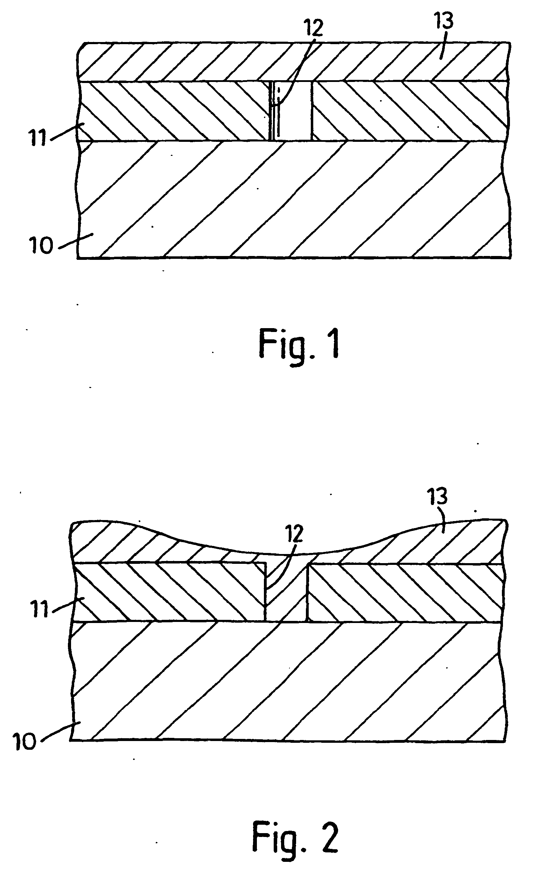

Figure 1 and 2 show a method useful for understanding the invention.

Figure 1 shows a semi-conductor wafer 10 with a pre existing layer or film 11 thereon. The wafer 10 itself may constitute a plurality of layers and/or regions of different properties, to form a semi conductor device, and will be the result of a fabrication process involving a plurality of stages for forming these layers and/or regions. The internal structure of the wafer 10 is not of significance in the present invention, and therefore these layers and/or regions will not be discussed further. The layer 11 has a hole or trench structure 12 therein, and this method is particularly concerned with the problem of filling the trench or hole 12 with material so as to allow vertically extending electrical connections to be formed between vertically spaced layers in the structure. In the simplest form of this method, an aluminium foil 13 is laid over the exposed surface of the layer 11 which would normally contain a vast number of holes 12. The foil 13 bridges all of these holes. Either before, during or after the foil 13 has been laid on the layer 11, the holes 12 are evacuated to a reduced pressure. The foil 13 may then be sealed around its periphery to the layer 11 or preferably pressurised gas is suddenly introduced into the chamber containing the wafer 10 and this will cause the foil to seal against the layer 11 closing off the holes 12 and creating a pressure drop across the thickness of the foil 13. Either before, or simultaneously with, the application of pressure the foil is heated to a temperature below its melting point and this combination of elevated pressure and temperature caused a localised movement of material in the foil so that the holes 12 are filled in the manner shown in Figure 2.

The thickness of the foil will usually be a function of the depth and/or the aspect ratio. Normally, prior to the application of the foil 13 a barrier layer of Titanium or Titanium Nitride may be deposited on the upper surface of the layer 11 and into the hole 12. This can have two functions: first it may prevent spiking of the aluminium or aluminium alloy into the layer 11 or wafer 10 and secondly it may act as a "lubricating" layer which facilitates the movement of aluminium in the foil into the hole 12.

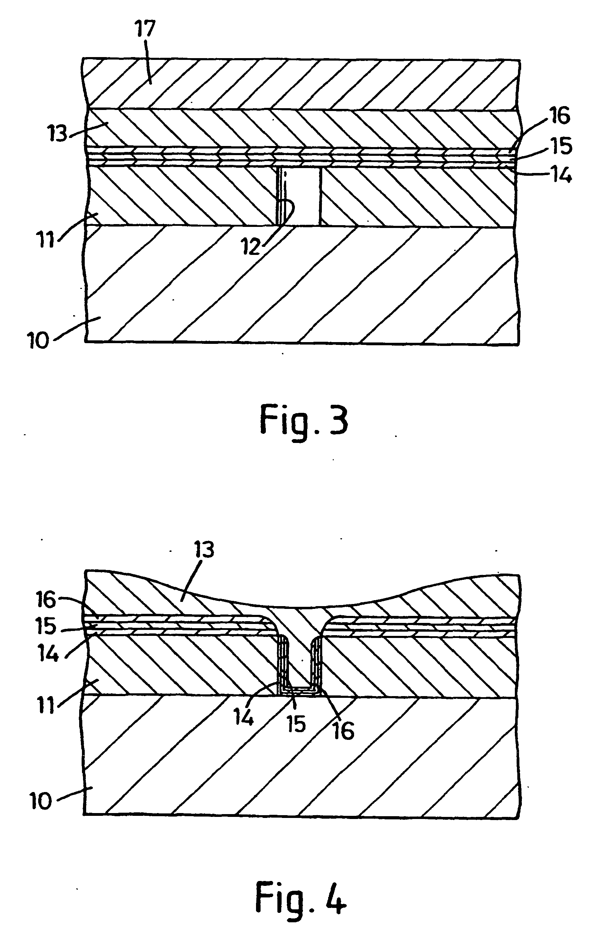

As present day manufacturing techniques require smaller and smaller holes to be filled, the deposition of this barrier layer into the hole 12 can be extremely difficult if not impossible. This situation can be addressed using the arrangement shown in Figures 3 and 4. In this case the aluminium 13 is coated on one side with barrier/lubricating layers 14, 15 and 16 which are made of Titanium/Nitride and Titanium respectively. However, a single layer of Titanium or Titanium Nitride may be used as may be layers of other suitable materials. For convenience the foil 13 is in this case carried on a carrier layer 17, which is preferably organic and may be mylar.

Once the foil 13 is laid onto the layer 11 the process continues as before, although at some stage the carrier layer 17 is stripped away, for example, using an oxygen or hydrogen plasma. As can be seen in Figure 4, the layers 14, 15 and 16 are cornered by the aluminium or alloy flowing into the hole 12 and form a lining of the hole 12. Thus the well known problems of shadowing etc. which occur when one tries to deposit a thin layer of material into an extremely narrow hole are overcome.

The holes of recesses filled may extend through many films or layers and they may form contacts on the layers or to pre-deposited conducting tracks.

As has been mentioned earlier the use of a foil, particularly one which is pre-prepared with lubricating or barrier layers, has considerable advantages, because the optimum arrangement of material, thickness etc can be provided irrespective of the process environment and the topography of the surface on which it is deposited.

## Claims

1. A method of filling recesses (12) formed in a film or layer (11) deposited on a substrate (10), comprising laying a metallic foil (13) across the exposed surface of the film to bridge the recesses, heating the foil and applying pressure to the foil whereby the foil or material therefrom is forced into the recesses to fill them, **characterised in that** the foil is mounted on or supported by a carrier layer (17) and **in that** the method further includes a step of stripping the carrier layer after laying said foil across said exposed surface.

2. A method as claimed in claim 1 wherein the carrier (17) is an organic material.

3. A method as claimed in claim 1 or claim 2 wherein the step of stripping the carrier layer (17) is performed prior to the application of pressure.

4. A method according to any one of the preceding claims, wherein the step of applying pressure comprises a pressure drop across the foil (13).

5. A method as claimed in any one of the preceding claims, wherein the foil (13) is aluminium or aluminium alloy.

6. A method as claimed in any one of the preceding claims wherein a barrier or lubricating layer (14) is deposited on that surface of the foil which engages the film surface.

7. A method as claimed in claim 6, wherein there is more than one barrier or lubricating layer (14-16).

## Patentansprüche

1. Verfahren zum Füllen von Vertiefungen (12) in einem Film oder einer Schicht (11), die auf einem Substrat (10) abgelegt ist, bei dem eine metallische Folie (13) über die freiliegende Oberfläche des Films gelegt wird, um die Vertiefungen zu überbrücken, die Folie erwärmt und Druck auf sie ausgeübt wird, um die Folie oder ihr Material in die Vertiefungen hineinzupressen und sie zu füllen, **dadurch gekennzeichnet, daß** die Folie auf einer Trägerschicht (17) angebracht oder von dieser getragen wird, und daß das Verfahren weiter vorsieht, daß die Trägerschicht, nachdem die Folie über die freiliegende Oberfläche gelegt worden ist, abgezogen wird.

2. Verfahren nach Anspruch 1, **dadurch gekennzeichnet, daß** die Trägerschicht (17) ein organisches Material ist.

3. Verfahren nach Anspruch 1 oder 2, **dadurch gekennzeichnet, daß** das Abziehen der Trägerschicht (17) geschieht, bevor der Druck angewendet wird.

4. Verfahren nach einem der vorhergehenden Ansprüche, **dadurch gekennzeichnet, daß** die Druckbeaufschlagung einen Druckabfall über der Folie (13) bedeutet.

5. Verfahren nach einem der vorhergehenden Ansprüche, **dadurch gekennzeichnet, daß** die Folie (13) aus Aluminium oder einer Aluminiumlegierung besteht.

6. Verfahren nach einem der vorhergehenden Ansprüche, **dadurch gekennzeichnet, daß** eine Sperr- oder Schmierstoffschicht (14) auf jene Oberfläche der Folie aufgebracht wird, die mit der Filmoberfläche in Berührung tritt.

7. Verfahren nach Anspruch 6, **dadurch gekennzeichnet, daß** mehr als eine Sperr- oder Schmierstoffschicht (14 - 16) aufgebracht wird.

## Revendications

1. Procédé de remplissage de cavités (12) formées dans un film ou une couche (11) déposé sur un substrat (10), comprenant les opérations consistant à poser une feuille métallique (13) à travers la surface exposée du film afin de ponter les cavités, chauffer la feuille et appliquer une pression à la feuille, ce par quoi la feuille ou le matériau de celle-ci est forcé dans les cavités afin de les remplir, **caractérisé par le fait que** la feuille est montée sur ou supportée par une couche de support (17) et **par le fait que** le procédé comprend en outre une étape de pelage de la couche de support après avoir posé ladite feuille à travers ladite surface exposée.

2. Procédé selon la revendication 1, dans lequel le support (17) est en une matière organique.

3. Procédé selon la revendication 1 ou la revendication 2, dans lequel l'étape de pelage de la couche de support (17) est effectuée avant l'application de pression.

4. Procédé selon l'une quelconque des revendications précédentes, dans lequel l'étape de l'application de la pression comprend une chute de pression à travers la feuille (13)

5. Procédé selon l'une quelconque des revendications précédentes, dans lequel la feuille (13) est en aluminium ou en alliage d'aluminium.

6. Procédé selon l'une quelconque des revendications précédentes, dans lequel une couche barrière ou lubrifiante (14) est déposée sur la surface de la feuille qui engage la surface du film.

7. Procédé selon la revendication 6, dans lequel il y a plus d'une couche barrière ou lubrifiante (14-16).
